# EUROPÄISCHE PATENTSCHRIFT

(11) **EP 1 267 303 B1**
(45) Veröffentlichungstag und Bekanntmachung des Hinweises auf die Patenterteilung: **27.07.2011**
(21) Anmeldenummer: 02012580.3
(22) Anmeldetag: 06.06.2002
(51) Int. Cl.: G06K 19/077, G06K 19/07

(54) **Transponder**
Transponder
Transpondeur

(30) Priorität: 11.06.2001 DE 20109655 U
(43) Veröffentlichungstag der Anmeldung: 18.12.2002
(73) Patentinhaber: HID Global GmbH, 65396 Walluf (DE)
(72) Erfinder: Kürschner, Hartmut, 99310 Amstadt (DE)
(74) Vertreter: Grosfillier, Philippe

(56) Entgegenhaltungen:
- EP-A1- 1 014 300
- EP-A1- 1 061 663
- WO-A1-00/36849
- FR-A- 2 680 262
- FR-A- 2 797 075
- NL-A- 9 301 540
- PATENT ABSTRACTS OF JAPAN vol. 1999, no. 05, 31. Mai 1999 (1999-05-31) & JP 11 031207 A (TOPPAN PRINTING CO LTD), 2. Februar 1999 (1999-02-02)

## Beschreibung

Die Erfindung betrifft einen kontaktloser Transponder, insbesondere zur Verwendung für kontaktlose Chipkarten, bei dem eine Antennenspule (2) mit einem Halbleiterchip (3.1) elektrisch leitend verbunden ist.

Als kontaktlose Transponder werden dabei insbesondere kontaktlose Chipkarten, Waren oder Warenverpackungen mit eingearbeiteten Antennen und Transponderchip, elektronische kontaktlose Etiketten, Tickets, Wertscheine etc. Verstanden. Dabei ist es auch möglich, dass der Halbleiterchip in einem anschlussfähigen Gehäuse, welches ein oder mehrere Halbleiterchips und gegebenenfalls einen oder mehrere Kondensatoren und/oder andere elektronische Komponenten enthält, angeordnet ist.

Als Stand der Technik sind Anordnungen bekannt, bei denen auf einem elektrisch isolierenden Träger, z.B. der thermoplastischen Folie einer Chipkarte, zwei oder mehrere Transponder gemeinsam angeordnet sind, die jeweils aus einer Transponderspule und einem Chipmodul bestehen.

Die Herstellung von Spulen auf thermoplastischen Folien erfolgt bevorzugt durch Ätzen oder Drahtlegen. Bei letztgenanntem Verfahren ist es üblich, das Einbringen von Draht in die Oberflächenschicht des thermoplastischen Substrates durch Wärmeeinwirkung und/oder Ultraschallschwingungen zu bewirken bzw. zu unterstützen.
Bei dem erfindungsgemäßen Transponder ist es auch möglich, dass die Leiteranordnung in verschiedenen Ebenen innerhalb des thermoplastischen Trägermaterials verläuft, so dass auch elektrisch nicht isolierte Leiter gekreuzt werden können ohne einen elektrischen Kontakt zu bilden. Dabei werden die isoliert zu kreuzenden unteren Leiterstücke vor dem Aufbringung der weiteren Leiterstücke zumindest im Kreuzungsbereich durch Druck mit thermischer und/oder Ultraschallunterstützung in die thermoplastische Schicht abgesenkt und danach die oberen Leiterzüge in bzw. auf die Oberflächenschicht gebracht.
Um eine geringe Dicke des Transponders zu ermöglichen, ist das Modul, in dem sich der Chip befindet, in einem Durchbruch des Trägermaterials angeordnet.

Nachteilig ist hierbei, dass ein mehrfacher Aufwand zur Herstellung der Spulenanordnung erforderlich ist und dass die Größe der Spulenabmessungen beschränkt ist.

Dokumente NL-A-9 310 540 und FR-A-2 680 262 offenbaren Karten mit einer Mehrzahl von Halbleiterchips. Beide Chips sind mit der gleichen Schnittstelle verbunden und die Karten können kontakbehaftet und/oder kontaktlos ausgeführt sein.

Der Erfindung liegt die Aufgabe zugrunde, einen Transponder der eingangs genannten Art anzugeben, der sowohl an einem als auch an mehreren Schreib-Lesesystemen funktionsfähig ist und mit geringem Aufwand kostengünstig herstellbar ist.

Die Aufgabe wird erfindungsgemäß mit einer Anordnung gelöst, welche die im Patentspruch 1 angegebenen Merkmale aufweist.

Vorteilhafte Ausgestaltungen sind in den Unteransprüchen angegeben.

Die Anordnung besteht aus einer Antennenspule sowie zwei oder mehreren Halbleiterchips. Die Halbleiterchips können in einem oder in mehreren Chipmodulen angeordnet sein. Es ist auch möglich, die Chips direkt auf die Antenne zu montieren, was beispielsweise mit einer Flip-Chip-Anwendung möglich ist.

Die Anordnung ermöglicht die Realisierung eines multi-systemfähigen Transponders, der die Form und die Abmessungen eines herkömmlichen Transponders aufweist. Damit wird ein Transponder geschaffen, welcher sowohl an einem als auch an mehreren Schreib-Lesesystemen funktionsfähig ist. Die Schreib-Lesesysteme müssen dabei nicht systemgleich sein. Es sind natürlich aber auch kontaktlose Transponder mit mindestens zwei systemgleichen Halbleiterchips herstellbar.

Die Erfindung zeichnet sich durch eine Reihe von Vorteilen aus. Hierzu gehören insbesondere:
1. Die Anordnung benötigt zum Betreiben mehrerer Transponder nur eine Antenne und einen Grundaufbau und ist deshalb kosten- und platzsparend.
2. Die parallelgeschalteten Eingangskapazitäten der Halbleiterchips können zur Parameterverbesserung genutzt werden. Dadurch ergibt sich eine Reduzierung der notwendigen Windungszahl und es besteht sich die Möglichkeit, hochwertigere Antennen zu schaffen.
3. Eventuell vorhandene Zusatzkapazitäten können gemeinsamen genutzt werden.
4. Die Anordnung ermöglicht es, kontaktlose Chipkarten mit einem sehr einfachen Aufbau zu schaffen.
5. Durch Verwendung nur eines Chipmoduls für mehrere Halbleiterchips, die beispielsweise in einem Gehäuse untergebracht werden können, besteht die Möglichkeit, einen mechanisch unempfindlichen Transponder sehr einfach und kostengünstig herzustellen.
6. Der vorhandene Speicherbereich und die Anzahl der nutzbaren Segmente können gegenüber bekannten Anordnungen erhöht werden.
7. Bei besonderen Anwendungen kann das Sicherheitsniveau deutlich gesteigert werden.

Die Erfindung wird im Folgenden anhand eines Ausführungsbeispiels näher erläutert.

In der dazugehörigen Zeichnung zeigen:
- Figur 1: eine herkömmliche Anordnung von zwei Transpondern auf einem Träger,
- Figur 2: die Draufsicht auf eine Anordnung, bei der zwei Halbleiterchips an der Antennenspule angeschlossen sind,
- Figur 3: einen Ausschnitt aus der thermoplastischen Basisfolie im Bereich der Kontaktstelle von Spulendrahtende und Chipanschlußfläche bei einer Ausführung, bei der sich die zu kontaktierende Drahtstelle auf der Basisfolie befindet
und
- Figur 4: die Draufsicht auf einen Ausschnitt aus der Trägerfolie, bei dem der Antennendraht in zwei Ebenen und mit einer Kreuzung verläuft.

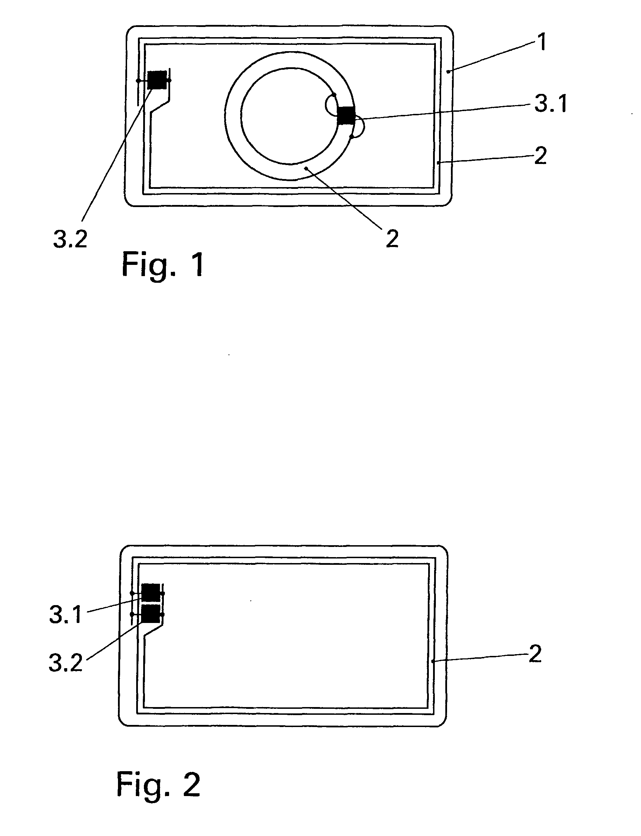

**Figur 1** zeigt eine aus dem Stand der Technik bekannte Ausführung, bei der zwei komplette Transponder mit jeweils einer Antennenspule 2 und jeweils einem Halbleiterchip3.1, 3.2 auf einem gemeinsamen Träger 1 angeordnet sind.

Eine erfindungsgemäße Ausführungsform ist in **Figur 2** dargestellt. Die Anordnung besteht aus der Antennenspule 2, die in einer Chipkarte aus thermoplastischem Material, welche den elektrisch isolierenden Träger 1 bildet, angeordnet ist sowie aus mindestens zwei, mit der Antennenspule 2 funktionsfähig verbundenen, voneinander unabhängig funktionierenden Halbleiterchips 3.1 und 3.2. Beide Halbleiterchips 3.1 und 3.2 sind mit der Antennenspule 2 elektrisch verbunden. Im Beispiel ist ein 13,56 MHz-Doppeltransponder dargestellt, bei dem je ein LEGIC®- sowie ein mifare® - Chip, die in zwei separaten Modulen untergebracht sind, mit einer Antenne verbunden sind.

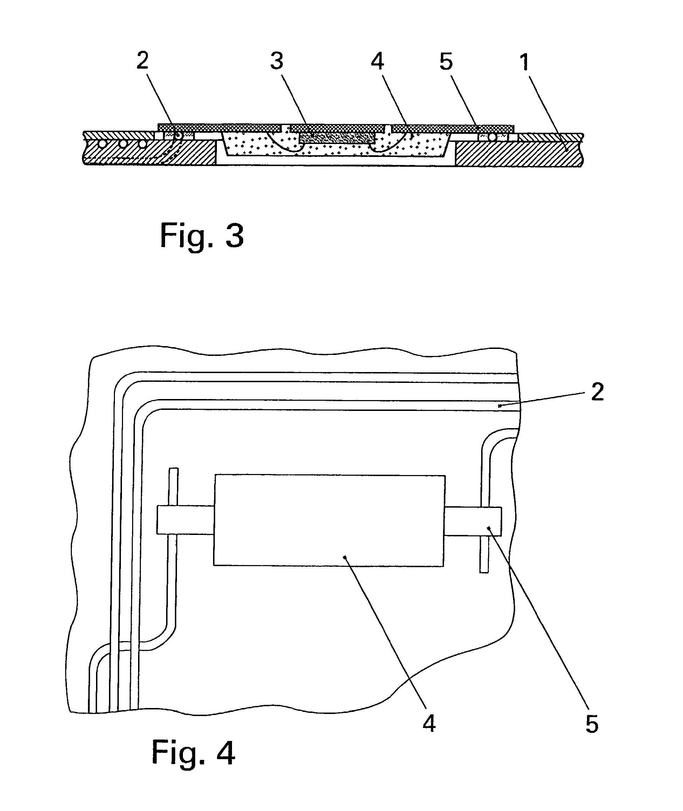

**Figur 3** zeigt ein Anwendungsmöglichkeit für eine Chipkarte mit kontaktlosem Doppeltransponder. In einem Modul 4 ist ein Chip 3 eingebettet, dessen Anschlussdrähte mit seitlich aus dem Modul 4 herausragenden Anschlussflächen 5 verbunden sind. Die Anschlussflächen 5 sind mittels Leitkleber mit den Anschlussstellen der Antennenspule 2 elektrisch leitend verbunden.
Ein Teilbereich der Antenne verläuft dabei in der oberen Ebene und ein Teilbereich in einer sich darunter befindenden Ebene des Trägers 1.
Das Modul 4 ist mit dem Träger 1 mit elektrisch leitendem Kleber verbunden, der sowohl die mechanische als auch die elektrisch leitende Verbindung der Anschlussflächen 5 mit der Antennenspule 2 gewährleistet. Ober- und unterhalb dieser Anordnung können Laminatschichten 7 angebracht sein. In diesem Fall verteilt sich der Kleber beim Laminieren und stellt den endgültigen Kontakt der Anschlussflächen 5 des Moduls 4 mit den Anschlussstellen der Antennenspule 2 her.

**Figur 4** zeigt eine Draufsicht auf den Kreuzungsbereich der Leiteranordnung. Die oberen Bereiche der Antennenspule 2 kreuzen elektrisch isoliert die auf die Unterseite des Trägers 1 gepresste untere Ebene der Antennenspule 2. Im Modul 4 sind zwei Halbleiterchips 3.1, 3.2 untergebracht.

### BEZUGSZEICHENLISTE

- 1: Träger
- 2: Antennenspule
- 3: Halbleiterchip
3.1 erstes Halbleiterchip
3.2 zusätzliches Halbleiterchip
- 4: Modul
- 5: Modulanschluss

## Patentansprüche

1. Kontaktloser Transponder, insbesondere zur Verwendung für kontaktlose Chipkarten, bei dem eine Antennenspule (2) mit einem Transponderchip (3.1) elektrisch leitend verbunden ist, **dadurch gekennzeichnet, dass** mindestens ein weiterer Transponderchip (3.2) ebenfalls mit der Antennenspule (2) elektrisch leitend verbunden ist, und dass die Kapazität des weiteren Transponderchips (3.2) mit der Kapazität des ersten Transponderchips (3.1) eine gemeinsam wirkende Gesamtkapazität bildet und die Antennenspule (2) auf die Arbeitsfrequenz des Transponders abgestimmt ist.

2. Kontaktloser Transponder nach Anspruch 1, **dadurch gekennzeichnet, dass** die Antennenspule (2) und die Transponderchips (3.1, 3.2) auf einem Träger (1) angeordnet sind.

3. Kontaktloser Transponder nach einem der vorhergehenden Ansprüche, **dadurch gekennzeichnet, dass** mindestens ein Transponderchip (3) in einem Chipmodul (4) angeordnet ist und die Anschlussdrähte des Halbleiterchips (3) zu Anschlussflächen (5) des Chipmoduls (4) geführt sind, die seitlich aus dem Chipmodul (4) herausgeführt werden und die mittels Leitkleber oder Druckkontakt mit Kontaktbereichen der Antennenspule (2) elektrisch leitend verbunden sind.

4. Kontaktloser Transponder nach Anspruch 3, **dadurch gekennzeichnet, dass** in einem Chipmodul (4) mehrere Transponderchips (3) angeordnet sind.

5. Kontaktloser Transponder nach einem der vorhergehenden Ansprüche, **dadurch gekennzeichnet, dass** die Antennenspule (2) in Drahtlegetechnik auf oder in den Träger (1) angebracht ist.

6. Kontaktloser Transponder nach Anspruch 5, **dadurch gekennzeichnet, dass** die Antennenspule (2) durch Drahtabsenken teilweise an oder auf der Oberseite und teilweise an der Unterseite einer Trägerfolie verläuft.

7. Kontaktloser Transponder nach einem der vorhergehenden Ansprüche, **dadurch gekennzeichnet, dass** die Antennenspule (2) mit dem Anschlussdraht des Halbleiterchips (1) oder mit dem Modulanschluss (5) kreuzt und mindestens im Kreuzungsbereich in eine untere Ebene des Trägers (1) abgesenkt ist..

8. Kontaktloser Transponder nach Anspruch 6 oder 7, **dadurch gekennzeichnet, dass** der Träger (1) aus zwei übereinander liegenden Folien besteht, wobei die obere Folie an den Stellen, an denen sich Kontaktbereiche der Antennenspule (2) befinden, Ausnehmungen aufweist.

9. Kontaktloser Transponder nach einem der Ansprüche 1 bis 3, **dadurch gekennzeichnet, dass** die Antennenspule (2) durch Ätzen auf den Träger (1) aufgebracht ist.

10. Kontaktloser Transponder nach einem der vorhergehenden Ansprüche, **dadurch gekennzeichnet, dass** die Antennenspule (2) mit einer für die Transponderchips (1) wirksamen Zusatzkapazität elektrisch verbunden ist.

## Claims

1. Contactless transponder, particularly for use for contactless chip cards, in which an antenna coil (2) is electrically conductively connected to a transponder chip (3.1), **characterized in that** at least one further transponder chip (3.2) is likewise electrically conductively connected to the antenna coil (2), and **in that** the capacitance of the further transponder chip (3.2) forms a jointly effective total capacitance with the capacitance of the first transponder chip (3.1), and the antenna coil (2) is attuned to the operating frequency of the transponder.

2. Contactless transponder according to Claim 1, **characterized in that** the antenna coil (2) and the transponder chips (3.1, 3.2) are arranged on a carrier (1).

3. Contactless transponder according to one of the preceding claims, **characterized in that** at least one transponder chip (3) is arranged in a chip module (4) and the connecting wires of the semiconductor chip (3) are routed to pads (5) on the chip module (4) which are routed laterally out of the chip module (4) and which are electrically conductively connected to contact areas of the antenna coil (2) by means of conductive adhesive or pressure contact.

4. Contactless transponder according to Claim 3, **characterized in that** a chip module (4) contains a plurality of transponder chips (3).

5. Contactless transponder according to one of the preceding claims, **characterized in that** the antenna coil (2) is mounted on or in the carrier (1) using wire installing technology.

6. Contactless transponder according to Claim 5, **characterized in that** the antenna coil (2) runs partly against or on the top and partly against the underside of a carrier film as a result of wire sinking.

7. Contactless transponder according to one of the preceding claims, **characterized in that** the antenna coil (2) crosses the connecting wire of the semiconductor chip (1) or crosses the module connection (5) and is sunk in a lower level of the carrier (1) at least in the crossing area.

8. Contactless transponder according to Claim 6 or 7, **characterized in that** the carrier (1) comprises two films situated above one another, wherein the upper film has recesses at the locations at which contact areas of the antenna coil (2) are situated.

9. Contactless transponder according to one of Claims 1 to 3, **characterized in that** the antenna coil (2) has been put onto the carrier (1) by means of etching.

10. Contactless transponder according to one of the preceding claims, **characterized in that** the antenna coil (2) is electrically connected to a supplementary capacitance which is effective for the transponder chips (1).

## Revendications

1. Transpondeur sans contact, notamment destiné à être utilisé pour des cartes à puce sans contact, dans lequel une bobine d'antenne (2) est reliée de manière électriquement conductrice avec une puce de transpondeur (3.1), **caractérisé en ce qu'**au moins une puce de transpondeur supplémentaire (3.2) est également reliée de manière électriquement conductrice avec la bobine d'antenne (2) et **en ce que** la capacité de la puce de transpondeur supplémentaire (3.2) forme avec la capacité de la première puce de transpondeur (3.1) une capacité totale à action commune et la bobine d'antenne (2) est accordée sur la fréquence de fonctionnement du transpondeur.

2. Transpondeur sans contact selon la revendication 1, **caractérisé en ce que** la bobine d'antenne (2) et les puces de transpondeur (3.1, 3.2) sont disposées sur un support (1).

3. Transpondeur sans contact selon l'une des revendications précédentes, **caractérisé en ce qu'**au moins une puce de transpondeur (3) est disposée dans un module à puce (4) et les fils de raccordement de la puce en semiconducteur (3) sont acheminés jusqu'à des surfaces de contact (5) du module à puce (4), lesquelles sortent latéralement hors du module à puce (4) et sont reliées de manière électriquement conductrice avec des zones de contact de la bobine d'antenne (2) au moyen d'une colle conductrice ou par contact à pression.

4. Transpondeur sans contact selon la revendication 3, **caractérisé en ce que** plusieurs puces de transpondeur (3) sont disposées dans un module à puce (4).

5. Transpondeur sans contact selon l'une des revendications précédentes, **caractérisé en ce que** la bobine d'antenne (2) est appliquée sur ou dans le support (1) par technique de pose de fil.

6. Transpondeur sans contact selon la revendication 5, **caractérisé en ce que** la bobine d'antenne (2), par abaissement du fil, s'étend en partie contre ou sur le côté supérieur et en partie contre le côté inférieur d'un film porteur.

7. Transpondeur sans contact selon l'une des revendications précédentes, **caractérisé en ce que** la bobine d'antenne (2) croise le fil de raccordement de la puce en semiconducteur (1) ou le raccordement du module (5) et elle est abaissée au moins dans la zone de l'intersection dans un plan inférieur du support (1).

8. Transpondeur sans contact selon la revendication 6 ou 7, **caractérisé en ce que** le support (1) se compose de deux films disposés l'un au-dessus de l'autre, le film supérieur présentant des évidements aux endroits où se trouvent des zones de contact de la bobine d'antenne (2).

9. Transpondeur sans contact selon l'une des revendications 1 à 3, **caractérisé en ce que** la bobine d'antenne (2) est appliquée sur le support (1) par gravure.

10. Transpondeur sans contact selon l'une des revendications précédentes, **caractérisé en ce que** la bobine d'antenne (2) est reliée de manière électriquement conductrice avec un condensateur supplémentaire actif pour la puce de transpondeur (1).
